# EUROPEAN PATENT APPLICATION

(11) **EP 4 654 474 A1**
(43) Date of publication of application: **26.11.2025**
(21) Application number: 23917006.1
(22) Date of filing: 14.07.2023
(51) Int. Cl.: H03H 9/02, H03H 9/205, H03H 3/02

(54) **BULK ACOUSTIC WAVE RESONATOR ASSEMBLY WITH HOLLOW BOTTOM ELECTRODES INSULATED FROM EACH OTHER**

(30) Priority: 19.01.2023 CN 202310078378
(71) Applicant: Rofs Microsystem (Tianjin) Co., Ltd, Tianjin 300462 (CN)
(72) Inventor: HAO, Long, Tianjin 300462 (CN); ZHANG, Wei, Tianjin 300462 (CN); JI, Yanli, Tianjin 300462 (CN); JIANG, Xingyong, Tianjin 300462 (CN); ZHANG, Lanyue, Tianjin 300462 (CN); ZHENG, Zhiqiang, Tianjin 300462 (CN); HUANG, Yuanqing, Tianjin 300462 (CN)
(74) Representative: Bandpay & Greuter
(86) International application number: PCT/CN2023/107510
(87) International publication number: WO 2024/152534

(57) **Abstract**

The present disclosure relates to a bulk acoustic wave resonator assembly and its manufacturing method, the assembly comprising: two adjacent bulk acoustic wave resonators disposed on a substrate, wherein bottom electrodes of the two adjacent bulk acoustic wave resonators each comprise a first bottom electrode and a second bottom electrode electrically connected to each other, and an acoustic mirror cavity is defined between the first bottom electrode and the second bottom electrode; and a shared release via, wherein the acoustic mirror cavities of the two adjacent bulk acoustic wave resonators communicate with the shared release via through respective release channels, wherein: in a cross-section which is parallel to a thickness direction of the assembly and passes through the shared release via and the release channel communicating with the shared release via, the bottom electrodes of the two adjacent bulk acoustic wave resonators are spaced apart from each other. The present disclosure also relates to a filter and an electronic device.

## Description

### TECHNICAL FIELD

Embodiments of the present disclosure relate to the field of semiconductors, and more particularly, to a bulk acoustic wave resonator assembly with hollow bottom electrodes insulated from each other, a manufacturing method thereof, a filter comprising the resonator assembly, and an electronic device.

### BACKGROUND

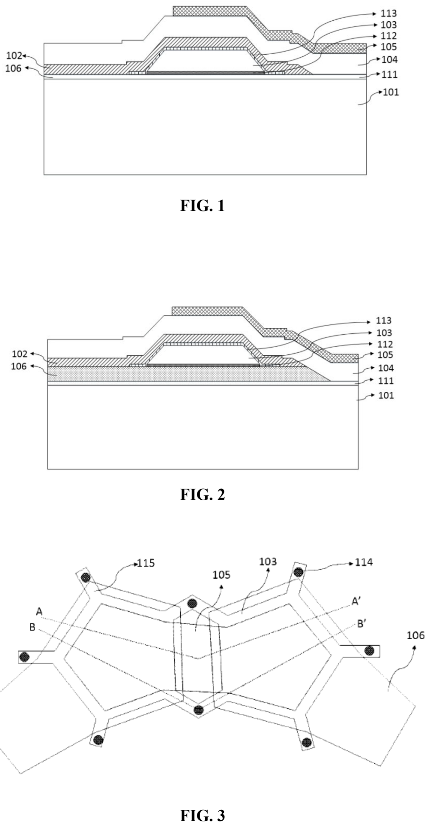

In existing bulk acoustic wave resonators, an acoustic mirror cavity may be disposed below the bottom electrode, as shown in FIG. 1. The acoustic mirror cavity may also be disposed within the bottom electrode, i.e., the bottom electrode is a hollow gap electrode, as shown in FIG. 2. Using the hollow gap bottom electrode as shown in FIG. 2 eliminates the need to form an acoustic mirror in the substrate and also helps reduce the impedance of the resonator.

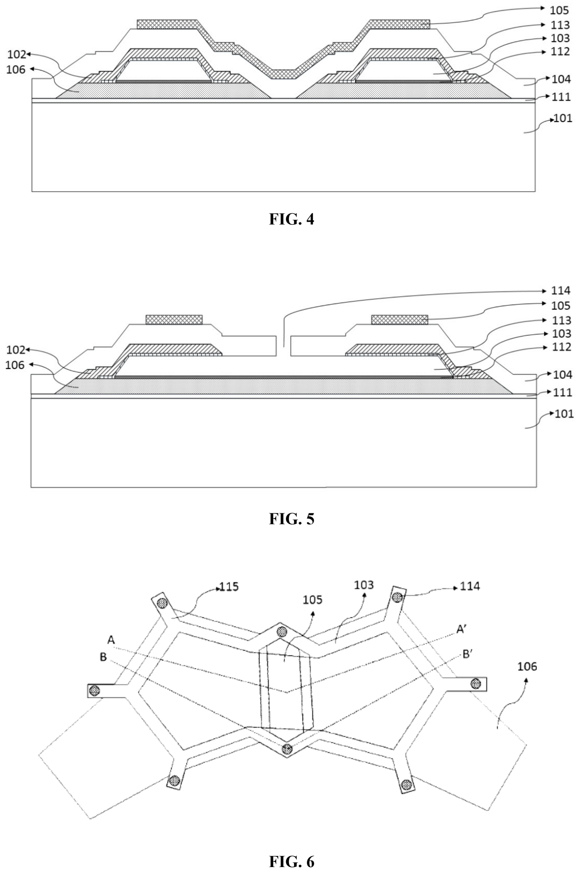

During resonator integration, to prevent the bottom electrodes of two adjacent resonators in FIG. 2 from being electrically connected, separate release vias are required to remove the sacrificial layer and form the acoustic mirror cavity. This occupies additional area, resulting in insufficient integration density of the resonators. If these two adjacent resonators share a common release via, the release channels (formed by patterning and releasing the sacrificial layer) connected to the acoustic mirror cavity would cause the bottom electrode layers beneath the sacrificial layers of the two adjacent resonators to become electrically connected. In some cases, this may prevent the resonators from functioning properly. Specifically, FIG. 3 shows a schematic top view of the assembly formed by two adjacent bulk acoustic wave resonators in FIG. 2. FIG. 4 is a cross-sectional view along the A-A' direction in FIG. 3, and FIG. 5 is a cross-sectional view along the B-B' direction in FIG. 3. As shown in FIG. 4, the second bottom electrodes 106 are disconnected at non-release channel locations in the structure. However, in the structure depicted in FIG. 5, if release channels 115 are formed, the second bottom electrodes 106 of the two resonators become connected at the bottom, rendering the two resonators non-functional.

### SUMMARY

The present disclosure is proposed to alleviate or resolve at least one aspect of the aforementioned issues in the prior art.

According to one aspect of an embodiment of the present disclosure, a bulk acoustic wave resonator assembly is provided, comprising:
two adjacent bulk acoustic wave resonators disposed on a substrate, wherein bottom electrodes of the two adjacent bulk acoustic wave resonators each comprise a first bottom electrode and a second bottom electrode electrically connected to each other, and an acoustic mirror cavity is defined between the first bottom electrode and the second bottom electrode; and
a shared release via, wherein the acoustic mirror cavities of the two adjacent bulk acoustic wave resonators communicate with the shared release via through respective release channels,
wherein:
   in a cross-section which is parallel to a thickness direction of the assembly and passes through the shared release via and the release channel communicating with the shared release via, the bottom electrodes of the two adjacent bulk acoustic wave resonators are spaced apart from each other.

An embodiment of the present disclosure also relates to a method for manufacturing a bulk acoustic wave resonator assembly. The assembly comprises two adjacent bulk acoustic wave resonators disposed on a substrate, and a shared release via, wherein bottom electrodes of the two adjacent bulk acoustic wave resonators each comprise a first bottom electrode and a second bottom electrode electrically connected to each other, an acoustic mirror cavity is defined between the first bottom electrode and the second bottom electrode, and the acoustic mirror cavities of the two adjacent bulk acoustic wave resonators communicate with the shared release via respective release channels. The method comprising the following steps of:
in a cross-section which is parallel to a thickness direction of the assembly and passes through the shared release via and the release channel communicating with the shared release via, spacing apart the bottom electrodes of the two adjacent bulk acoustic wave resonators from each other.

An embodiment of the present disclosure also relates to a filter, comprising the aforementioned bulk acoustic wave resonator assembly.

An embodiment of the present disclosure further relates to an electronic device, comprising the aforementioned filter or the aforementioned resonator assembly.

### BRIEF DESCRIPTION OF DRAWINGS

The description and drawings can better assist in understanding these and other features and advantages of the various embodiments disclosed in the present disclosure, wherein the same reference numerals consistently denote the same components, in which:
FIG. 1 is a schematic cross-sectional view of a known bulk acoustic wave resonator, where the bottom electrode is not a gap electrode;
FIG. 2 is a schematic cross-sectional view of a known bulk acoustic wave resonator, where the bottom electrode is a gap electrode;
FIG. 3 is a schematic top view of an assembly formed by two adjacent bulk acoustic wave resonators in FIG. 2;
FIG. 4 is a cross-sectional view taken along line A-A' in FIG. 3;
FIG. 5 is a cross-sectional view taken along line B-B' in FIG. 3;
FIG. 6 is a schematic top view of a bulk acoustic wave resonator assembly according to an exemplary embodiment of the present disclosure;
FIG. 7 is a cross-sectional view taken along line B-B' in FIG. 6;
FIGS. 8-16 are schematic cross-sectional views illustrating the manufacturing process of the bulk acoustic wave resonator assembly shown in FIG. 7 according to an exemplary embodiment of the present disclosure;
FIG. 17 is a variant embodiment of the bulk acoustic wave resonator assembly shown in FIG. 7;
FIG. 18 is another variant embodiment of the bulk acoustic wave resonator assembly shown in FIG. 7;
FIG. 19 is an enlarged view of the acoustic mismatch structure in FIG. 18;
FIG. 20 is a schematic cross-section view of a bulk acoustic wave resonator assembly according to yet another exemplary embodiment of the present disclosure, which is also a variant of the structure shown in FIG. 7;
FIG. 21 is a schematic top view of a bulk acoustic wave resonator assembly according to still another exemplary embodiment of the present disclosure;
FIG. 22 is a cross-section view taken along line B-B' in FIG. 21;
FIGS. 23-24 are variant examples of the structure shown in FIG. 22;
FIG. 25 is an enlarged view of the acoustic mismatch structure in FIG. 24;
FIGS. 26-32 are schematic cross-section views illustrating the manufacturing process of the bulk acoustic wave resonator assembly shown in FIG. 22 according to an exemplary embodiment of the present disclosure.

### DESCRIPTION OF EMBODIMENTS

The technical solutions of the present disclosure are further described below in detail through embodiments and with reference to the accompanying drawings. In the specification, the same or similar reference numerals indicate the same or similar components. The description of the embodiments of the present disclosure with reference to the drawings is intended to explain the general inventive concept of the present disclosure and should not be construed as a limitation thereof. The embodiments described herein represent only a part of the embodiments of the present disclosure and not all of them. All other embodiments obtained by those of ordinary skill in the art based on the embodiments of the present disclosure shall fall within the scope of protection of the present disclosure.

In the present disclosure, the issue of two adjacent second bottom electrodes 106 being connected is resolved by directly disconnecting them at the release channel.

First, the reference signs in the drawings of the present disclosure are explained as follows:
101: Substrate, optional materials of which include monocrystalline silicon, gallium nitride, gallium arsenide, sapphire, quartz, silicon carbide, diamond, etc.
102: First bottom electrode (including electrode leads), optional materials of which include: molybdenum, ruthenium, gold, aluminum, magnesium, tungsten, copper, titanium, iridium, osmium, chromium, or composites or alloys of the above metals.
103: Acoustic mirror cavity, which adopts a gap electrode configuration in the embodiment shown in the present disclosure.
104: Piezoelectric layer, which can be a single-crystal piezoelectric material, and selected from the group including: single-crystal aluminum nitride, single-crystal gallium nitride, single-crystal lithium niobate, single-crystal lead zirconate titanate (PZT), single-crystal potassium niobate, single-crystal quartz film, or single-crystal lithium tantalate, etc.; it may also be a polycrystalline piezoelectric material (as opposed to single-crystal, non-single-crystal materials), which is selected from the group including: polycrystalline aluminum nitride, zinc oxide, PZT, etc.; it may also be rare-earth element-doped materials with a certain atomic ratio of the aforementioned materials, for example, doped aluminum nitride, which contains at least one rare-earth element such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu), etc.
105: Top electrode (including electrode pins), with optional materials such as molybdenum, ruthenium, gold, aluminum, magnesium, tungsten, copper, titanium, iridium, osmium, chromium, or composites or alloys of the above metals. The materials of the top electrode and the bottom electrode are generally the same but can also differ.
106: Second bottom electrode (including electrode pins) electrically connected to the first bottom electrode, with optional materials such as molybdenum, ruthenium, gold, aluminum, magnesium, tungsten, copper, titanium, iridium, osmium, chromium, or composites or alloys of the above metals.
107: Passivation layer or process layer placed on the top electrode of the resonator, which can be a mass-adjusting load or passivation layer. Its material can be a dielectric material, such as AlN, SiN, Al₂O₃, SiO₂, etc.
108: Edge layer structure, such as an air gap above the piezoelectric layer. The materials of the edge layer structure include air or functional materials for reflecting acoustic waves, where the acoustic impedance of the functional material is less than or equal to that of air.
109: Protrusion structure above the piezoelectric layer, with optional materials such as molybdenum, ruthenium, gold, aluminum, magnesium, tungsten, copper, titanium, iridium, osmium, chromium, or composites or alloys of the above metals. Non-metallic materials such as AlN, SiN, SiO₂, etc., can also be selected.
110: Sacrificial layer, the material of which may be AlN, SiN, SiO₂.
111: Insulating layer, the material of which may be AlN, SiN, SiO₂.
112: Etch stop layer, the material of which may be AlN, SiN, SiO₂.
113: Seed layer, the material of which may be AlN.
114: Release via.
114a/114b: Release vias at the shared release channel.
115: Release channel.
116: Recess.

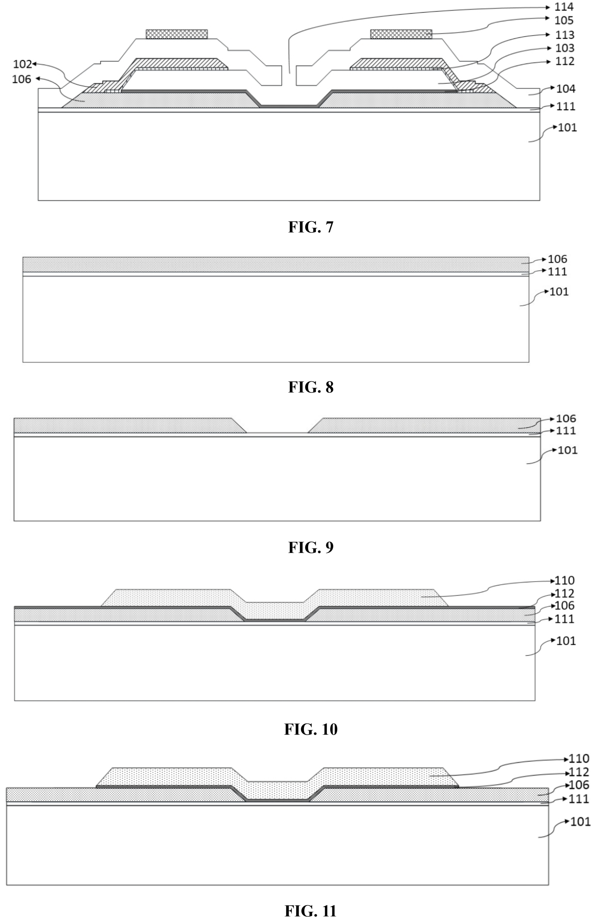

FIG. 6 is a schematic top view of a bulk acoustic wave resonator assembly according to an exemplary embodiment of the present disclosure, and FIG. 7 is a cross-sectional view taken along line B-B' in FIG. 6. The cross-sectional view along line A-A' in FIG. 6 is consistent with or similar to that in FIG. 4 and will not be repeated here.

As shown in FIG. 7, in the cross-section which is parallel to the thickness direction and passes through the shared release via 114 and the release channel 115 communicating with the release via 114, the second bottom electrodes 106 of two adjacent bulk acoustic wave resonators are spaced apart from each other.

As shown in FIG. 7, the shared release via 114 passes through the piezoelectric layer 104 and the second bottom electrode 106. The second bottom electrode 106 is arranged closer to the substrate 101 of the assembly compared to the first bottom electrode 102. In the cross-section shown in FIG. 7, the second bottom electrodes 106 of two adjacent bulk acoustic wave resonators are spaced apart from each other.

With the structure shown in FIG. 7, the two adjacent bulk acoustic wave resonators share the release via 114 while avoiding electrical connection between their second bottom electrodes 106 at or near the release via 114, thereby resolving the technical issues present in the prior art.

FIGS. 8-16 are schematic cross-sectional views illustrating the manufacturing process of the bulk acoustic wave resonator assembly shown in FIG. 7 according to an exemplary embodiment of the present disclosure, as described below.

Step 1: as shown in FIG. 8, an insulating layer 111 and an electrode layer of a second bottom electrode 106 are sequentially deposit on a substrate 101.

Step 2: as shown in FIG. 9, the electrode layer of the second bottom electrode 106 is patterned through processes such as photolithography and etching to form the structure shown in FIG. 9.

Step 3: the material layers of the etch stop layer 112 and a sacrificial layer 110 are sequentially deposited; the sacrificial layer 110 is patterned through photolithography and etching to form the structure shown in FIG. 10, with etching stopping at the etch stop layer 112. The sacrificial layer 110 fills the voids formed by removing the electrode layer of the second bottom electrode 106 in Step 2.

Step 4: the etch stop layer 112 of the sacrificial layer is etched to form the structure shown in FIG. 11.

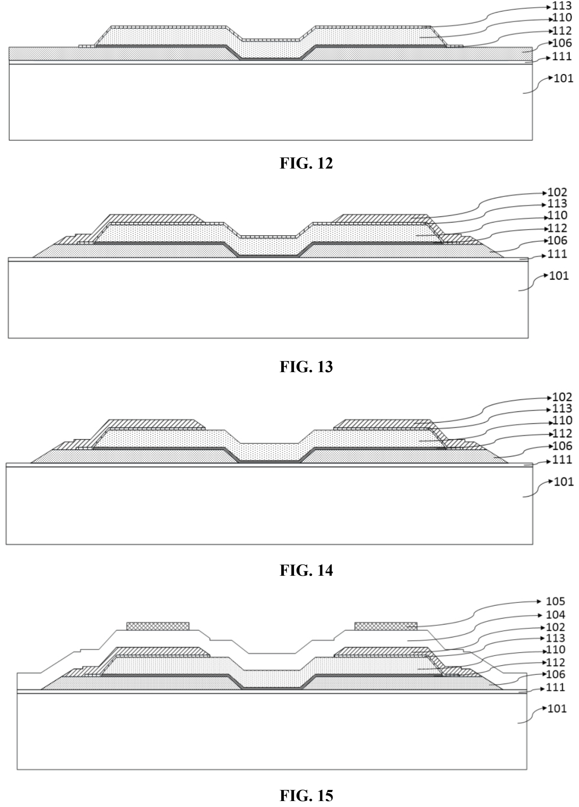

Step 5: the material layer of a seed layer 113 is deposited, and then patterned through photolithography and etching to form the structure shown in FIG. 12.

Step 6: the electrode layer of the first bottom electrode 102 is deposited, and then patterned through photolithography and etching to obtain the structure shown in FIG. 13. It can be seen that the electrode layers of the first bottom electrode 102 and the second bottom electrode 106 are etched together, with etching stopping at the seed layer 113 at connection position of the sacrificial layer.

Step 7: the seed material layer is etched away except for the first bottom electrode 102 to obtain the seed layer 113, resulting in the structure shown in FIG. 14.

Step 8: a piezoelectric thin film or a piezoelectric layer 104 and the electrode layer of a top electrode 105 are sequentially deposited, and then the electrode layer of the top electrode 105 is patterned through processes such as photolithography and etching, resulting in the structure shown in FIG. 15.

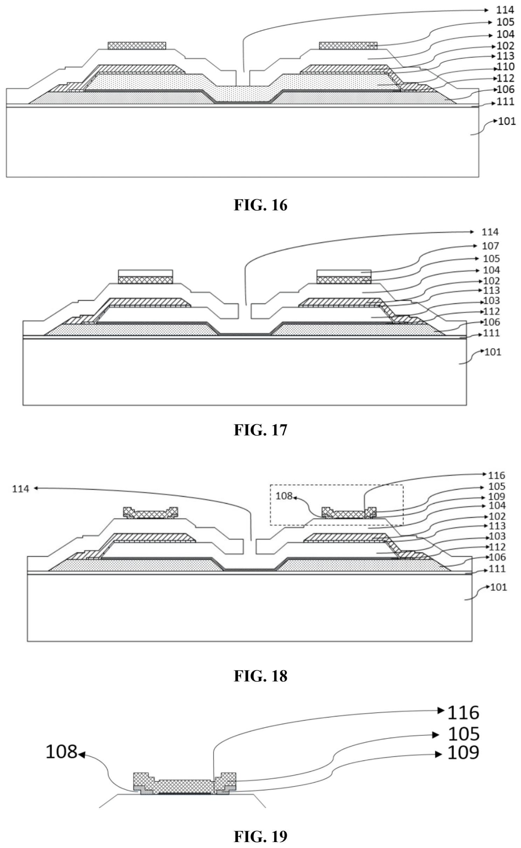

Step 9: a release via 114 is created through processes such as photolithography and etching, as shown in FIG. 16.

Step 10: the sacrificial layer 110 is removed through the release via 114, resulting in the structure shown in FIG. 7.

Based on the above method, the manufacturing method of the bulk acoustic wave resonator assembly proposed by the present disclosure includes the following steps:
disposing a second bottom electrode layer on a substrate and patterning the second bottom electrode layer such that the portions corresponding to a shared release via and a release channel between adjacent bulk acoustic wave resonators are removed;
forming a sacrificial layer on the patterned second bottom electrode layer, where the sacrificial layer is used to create an acoustic mirror cavity and the release channel, and the sacrificial layer fills the removed portions between the second bottom electrode layers of adjacent bulk acoustic wave resonators;
forming other film layers of the assembly;
forming the shared release via that penetrates a piezoelectric layer of the assembly and reaches the portion of the sacrificial layer used to form the release channel; and
releasing the sacrificial layer through the shared release via to form the acoustic mirror cavity and release channel.

FIG. 17 shows a variant embodiment of the bulk acoustic wave resonator assembly illustrated in FIG. 7. Compared to the structure in FIG. 7, FIG. 17 includes a passivation or process layer 107 on the upper side of the top electrode 105, while other structures remain the same as in FIG. 7 and are not repeated here.

FIG. 18 shows another variant embodiment of the bulk acoustic wave resonator assembly illustrated in FIG. 7, and FIG. 19 is an enlarged view of the acoustic mismatch structure in FIG. 18. Compared to the structure in FIG. 7, FIG. 18 incorporates an acoustic mismatch structure, while other structures remain the same as in FIG. 7 and are not repeated here. As shown in FIG. 19, the acoustic mismatch structure includes an edge layer structure 108, a protrusion structure 109 above the piezoelectric layer, and a recess 116. The edge layer structure 108, the protrusion structure 109 and the recess 116 may be implemented individually or in combination. The structure in FIG. 18 can increase the Q value of the resonator.

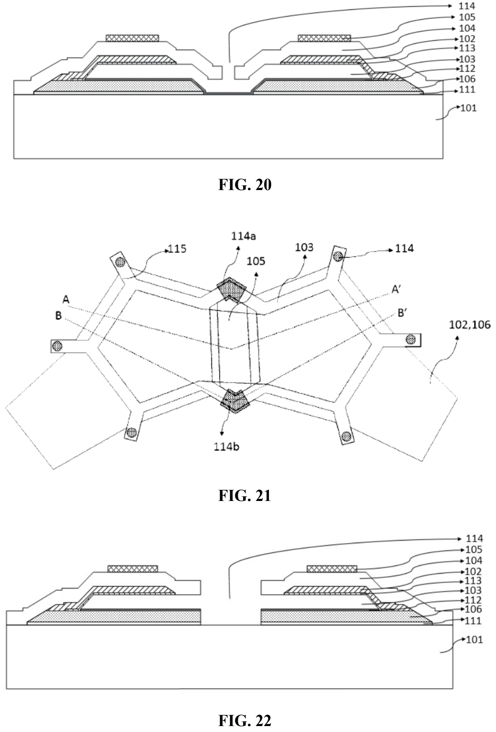

FIG. 20 is a schematic cross-sectional view of a bulk acoustic wave resonator assembly according to yet another exemplary embodiment of the present disclosure, which is also a variant of the structure shown in FIG. 7. Compared to the structure in FIG. 7, the insulating layer 111 in FIG. 20 is etched away in areas not covered by the second bottom electrode 106, while other structures remain the same as in FIG. 7 and are not repeated here.

FIG. 21 is a schematic top view of a bulk acoustic wave resonator assembly according to yet another exemplary embodiment of the present disclosure, and FIG. 22 is a cross-sectional view taken along line B-B' in FIG. 21. The cross-sectional view along line A-A' in FIG. 21 is identical or similar to that in FIG. 4 and thus will not be repeated here.

Referring to FIGS. 21 and 22, when fabricating the release vias 114, their dimensions must be enlarged to be greater or wider than the release channels 115, such as release vias 114a and 114b. The widths of release vias 114a and 114b exceed those of the release channel 115 and fully cover it, thereby enabling the electrical connection between the two second bottom electrodes 106 to be severed via the release vias. As shown in FIG. 22, during the formation of release vias 114, the piezoelectric layer 104, the second bottom electrode 106, the seed layer 113, the sacrificial layer 110, the etch stop layer 112 and the insulating layer 111 are all etched away. Subsequently, the sacrificial layer 110 is removed through processes like etching to form the final structure. As can be understood, it suffices as long as the etching penetrates the piezoelectric layer 104, the sacrificial layer 110 and the second bottom electrode 106.

As illustrated in FIG. 22, in the cross-section, the lateral spacing between adjacent second bottom electrodes 106 of two bulk acoustic wave resonators differs from the via diameter of the release via 114 by no more than 3µm. More specifically, the lateral spacing equals the via diameter. Optionally, the via diameter falls within the range of 2 µm-100 µm.

With the structure shown in FIG. 22, adjacent bulk acoustic wave resonators share the release via 114 while avoiding electrical connection between their second bottom electrodes 106 at or near the release via, thereby resolving the technical issue present in prior art.

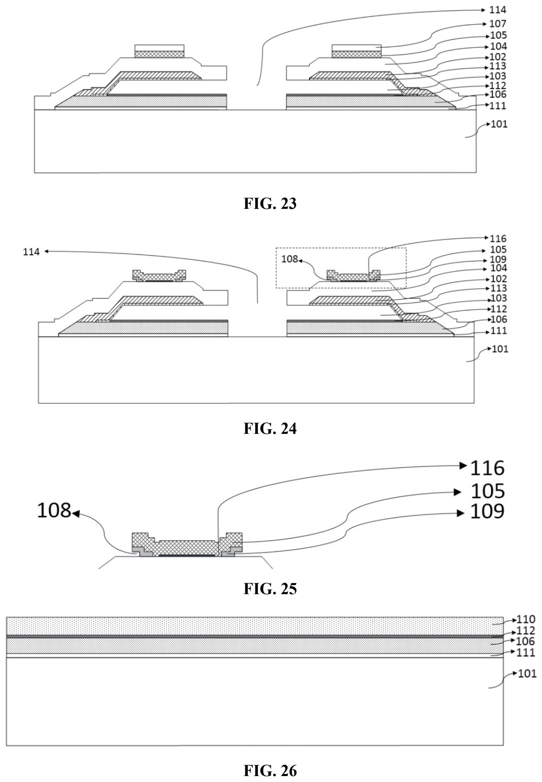

Additionally, compared to the structure in FIG. 7, the structure in FIG. 22 eliminates one step depicted in FIG. 9 during manufacturing, as described later with reference to FIGS. 26-32, thus reducing costs.

FIG. 23 shows a variant embodiment of the bulk acoustic wave resonator assembly illustrated in FIG. 22. In contrast to the structure in FIG. 22, FIG. 23 features a passivation or process layer 107 disposed on the upper side of the top electrode 105, while other structures remain identical to those in FIG. 23 and will not be reiterated here.

FIG. 24 shows another variant embodiment of the bulk acoustic wave resonator assembly illustrated in FIG. 22, and FIG. 25 is an enlarged view of the acoustic mismatch structure in FIG. 24. Compared to the structure shown in FIG. 22, the acoustic mismatch structure is added in FIG. 24, while the other structures remain the same as in FIG. 22 and will not be reiterated here. As shown in FIG. 25, the acoustic mismatch structure includes the edge layer structure 108, the protrusion structure 109 above the piezoelectric layer, and the recess 116. The edge layer structure 108, the protrusion structure 109 above the piezoelectric layer and the recess 116 may be implemented individually or in combination. The structure shown in FIG. 24 can increase the Q value of the resonator.

FIGS. 26-32 are schematic cross-sectional views illustrating the manufacturing process of the bulk acoustic wave resonator assembly shown in FIG. 22 according to an exemplary embodiment of the present disclosure, as described below.

Step 1: As shown in FIG. 26, the insulating layer 111, the second bottom electrode 106, the etch stop layer 112 and the sacrificial layer 110 are sequentially deposited on the substrate 101.

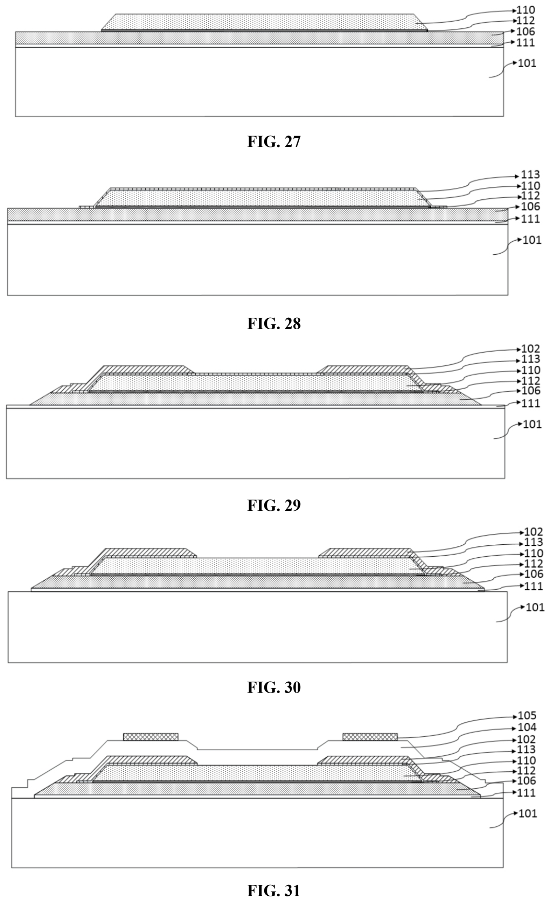

Step 2: As shown in FIG. 27, the sacrificial layer 110 and the etch stop layer 112 are patterned.

Step 3: As shown in FIG. 28, the seed layer 113 is deposited and then patterned to form the structure shown in FIG. 28.

Step 4: As shown in FIG. 29, the electrode layer of the first bottom electrode 102 is deposited, and then patterned to form the structure shown in FIG. 29.

Step 5: As shown in FIG. 30, the first bottom electrode 102 is used as an etch stop layer to etch the seed layer 113 and the insulating layer 111, forming the structure shown in FIG. 30.

Step 6: As shown in FIG. 31, the piezoelectric thin film or piezoelectric layer 104 and the electrode layer of the top electrode 105 are deposited, and then the electrode layer of the top electrode 105 is patterned to obtain the structure shown in FIG. 31.

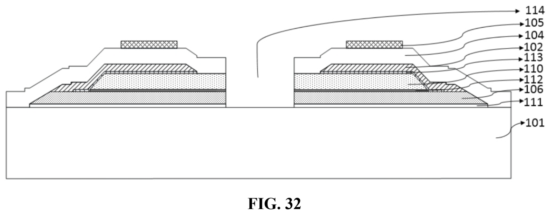

Step 7: As shown in FIG. 32, the release via 114 is formed through lithography and etching to achieve the structure shown in FIG. 32. During etching, the piezoelectric layer 104, the sacrificial layer 110, the etch stop layer 112, the second bottom electrode 106 and the insulating layer 111 are etched respectively.

Step 8: the sacrificial layer 111 is removed through the release via 114 to obtain the structure shown in FIG. 22.

Based on the above method, the manufacturing method of the bulk acoustic wave resonator assembly proposed by the present disclosure includes the following steps:
forming a second bottom electrode, a sacrificial layer, a first bottom electrode, a piezoelectric layer and a top electrode on the substrate, wherein the sacrificial layer defines a portion for forming a release channel;
at a predetermined position between the two adjacent bulk acoustic wave resonators, removing the piezoelectric layer, the sacrificial layer and the second bottom electrode to form a shared release via, which penetrates the piezoelectric layer, the sacrificial layer and the second bottom electrode, thereby separating the second bottom electrodes on both sides of the shared release via; and
releasing the sacrificial layer from the shared release via to form an acoustic mirror cavity and a release channel.

It should be noted that, in the present disclosure, each numerical range, unless explicitly stated to exclude endpoint values, may include the endpoint values as well as the median values of the respective numerical ranges, all of which fall within the scope of protection of the present disclosure.

In the present disclosure, "upper" and "lower" are defined relative to the bottom surface of the resonator's substrate. For a component, the side closer to this bottom surface is the lower side, and the side farther from it is the upper side.

In the present disclosure, "inner" and "outer" are defined relative to the center of the resonator's active region (the overlapping area of the piezoelectric layer, the top electrode, the bottom electrode and the acoustic mirror in the thickness direction of the resonator constitutes the active region), i.e., the active region center, in the lateral or radial direction. The side or end of a component closer to the active region center is the inner side or inner end, while the side or end farther from the active region center is the outer side or outer end. For a reference position, being on the inner side of the position means it lies between the position and the active region center in the lateral or radial direction, whereas being on the outer side means it is farther from the active region center than the position in the lateral or radial direction.

As those skilled in the art will appreciate, the bulk acoustic wave resonator according to the present disclosure can be used to form filters or other semiconductor devices.

The electronic devices mentioned here include, but are not limited to, intermediate products such as RF front-ends and filter amplification modules, as well as end products like mobile phones, WiFi devices, and drones.

Although embodiments of the present disclosure have been shown and described, those of ordinary skill in the art will understand that variations can be made to these embodiments without departing from the principles and spirit of the disclosure, the scope of which is defined by the appended claims and their equivalents.

## Claims

1. A bulk acoustic wave resonator assembly, comprising:
two adjacent bulk acoustic wave resonators disposed on a substrate, wherein bottom electrodes of the two adjacent bulk acoustic wave resonators each comprise a first bottom electrode and a second bottom electrode electrically connected to each other, and an acoustic mirror cavity is defined between the first bottom electrode and the second bottom electrode; and
a shared release via, wherein the acoustic mirror cavities of the two adjacent bulk acoustic wave resonators communicate with the shared release via through respective release channels,
wherein:
in a cross-section which is parallel to a thickness direction of the assembly and passes through the shared release via and the release channel communicating with the shared release via, the bottom electrodes of the two adjacent bulk acoustic wave resonators are spaced apart from each other.

2. The assembly according to claim 1, wherein:
the shared release via penetrates a piezoelectric layer of the assembly and the second bottom electrode, and the second bottom electrode is disposed closer to the substrate of the assembly than the first bottom electrode; and
in the cross-section, the second bottom electrodes of the two adjacent bulk acoustic wave resonators are spaced apart from each other.

3. The assembly according to claim 2, further comprising:
an etch stop layer, wherein in the cross-section, the etch stop layer covers upper sides of the second bottom electrodes of the two adjacent bulk acoustic wave resonators to define a lower side of the acoustic mirror cavity and covers a portion between the spaced-apart second bottom electrodes of the two adjacent bulk acoustic wave resonators to define a lower side of the release channel.

4. The assembly according to claim 3, further comprising:
an insulating layer disposed between the second bottom electrode and the substrate, wherein the etch stop layer covers the portion between the spaced-apart second bottom electrodes of the two adjacent bulk acoustic wave resonators of the insulating layer; or
an insulating layer disposed between the second bottom electrodes and the substrate, wherein the portion between the spaced-apart second bottom electrodes of the two adjacent bulk acoustic wave resonators of the insulating layer is removed such that the etch stop layer covers the substrate at a position where the insulating layer is removed.

5. The assembly according to claim 1, wherein:
the second bottom electrode is disposed closer to the substrate of the assembly than the first bottom electrode, and the shared release via penetrates the piezoelectric layer and the second bottom electrode of the assembly; and
in a top view of the assembly, the shared release via has a width greater than that of the release channel and fully covers the release channel.

6. The assembly according to claim 5, wherein:
in the cross-section, a difference between a lateral spacing of the second bottom electrodes of the two adjacent bulk acoustic wave resonators and a via diameter of the shared release via is no greater than 3 µm.

7. The assembly according to claim 6, wherein:
the lateral spacing is equal to the via diameter of the shared release via.

8. The assembly according to claim 6, wherein:
the via diameter is in a range of 2 µm-100 µm.

9. The assembly according to claims 1-8, further comprising:
an acoustic mismatch structure disposed along an edge of an active region of the bulk acoustic wave resonator; and/or
a passivation layer or a process layer covering at least a top electrode of the bulk acoustic wave resonator.

10. A method for manufacturing a bulk acoustic wave resonator assembly, wherein the assembly comprises two adjacent bulk acoustic wave resonators disposed on a substrate, and a shared release via, wherein bottom electrodes of the two adjacent bulk acoustic wave resonators each comprise a first bottom electrode and a second bottom electrode electrically connected to each other, an acoustic mirror cavity is defined between the first bottom electrode and the second bottom electrode, and the acoustic mirror cavities of the two adjacent bulk acoustic wave resonators communicate with the shared release via through respective release channels; and the method comprising the following steps of:
in a cross-section which is parallel to a thickness direction of the assembly and passes through the shared release via and the release channel communicating with the shared release via, spacing apart the bottom electrodes of the two adjacent bulk acoustic wave resonators from each other.

11. The method according to claim 10, wherein the second bottom electrode is disposed closer to the substrate of the assembly than the first bottom electrode, and the method comprises the following steps of:
forming the second bottom electrode layers on the substrate and patterning the second bottom electrode layers such that portions of the second bottom electrodes of the two adjacent bulk acoustic wave resonators corresponding to the shared release via and release channels are removed;
forming a sacrificial layer on the patterned second bottom electrode layers, wherein the sacrificial layer is configured to form the acoustic mirror cavities and the release channels, and the sacrificial layer fills the removed portions between the second bottom electrodes of the two adjacent bulk acoustic wave resonators;
forming other film layers of the assembly;
forming the shared release via penetrating the piezoelectric layer of the assembly to reach a portion of the sacrificial layer for forming the release channels; and
releasing the sacrificial layer from the shared release via to form the acoustic mirror cavities and a release channels.

12. The method according to claim 10, wherein the method comprises the following steps of:
disposing the second bottom electrode, a sacrificial layer, the first bottom electrode, the piezoelectric layer and a top electrode on the substrate, wherein the sacrificial layer defines a portion for forming the release channel;
removing the piezoelectric layer, the sacrificial layer and the second bottom electrode at a predetermined position between the two adjacent bulk acoustic wave resonators to form the shared release via, wherein the shared release via penetrates the piezoelectric layer, the sacrificial layer and the second bottom electrode, and the shared release via separates the second bottom electrodes on both sides of the shared release via; and
releasing the sacrificial layer from the shared release via to form the acoustic mirror cavity and the release channel.

13. A filter, comprising the bulk acoustic wave resonator assembly according to any one of claims 1-9.

14. An electronic device, comprising the filter according to claim 13 or the bulk acoustic wave resonator assembly according to any one of claims 1-9.
